Europäisches Patentamt

European Patent Office

Office européen des brevets

(11) Publication number: **0 250 776 B1**

# EUROPEAN PATENT SPECIFICATION

(19)

(12)

(45) Date of publication of patent specification: **10.06.92**   (51) Int. Cl.⁵: **G01R 31/08**, G01M 3/18

(21) Application number: **87106434.1**

(22) Date of filing: **29.06.84**

(60) Publication number of the earlier application in
accordance with Art.76 EPC: **0 133 748**

(54) **Method for detecting and obtaining information about changes in variables.**

(30) Priority: **30.06.83 US 509897**
**11.04.84 US 599047**
**24.04.84 US 603485**
**07.06.84 US 618109**

(43) Date of publication of application:
**07.01.88 Bulletin 88/01**

(45) Publication of the grant of the patent:
**10.06.92 Bulletin 92/24**

(84) Designated Contracting States:
**AT BE CH DE FR GB IT LI LU NL SE**

(56) References cited:
**AT-B- 58 704**
**DE-A- 3 225 742**
**US-A- 2 581 213**
**US-A- 3 800 216**
**US-A- 3 991 413**

(73) Proprietor: **RAYCHEM CORPORATION (a Delaware corporation)**
**300 Constitution Drive**
**Menlo Park, California 94025(US)**

(72) Inventor: **Brooks, Peter Leonard**
**611, Glen Alto**
**Los Altos California 94022(US)**
Inventor: **Reeder, Larry Russell**
**1182, Littleoak Drive**
**San Jose California 95129(US)**
Inventor: **Reed, James Patrick**
**1745, Beach Street No. 10**
**San Francisco California 94123(US)**
Inventor: **Tolles, Thomas Winton**
**3034, Jackson Street**
**San Francisco California 94115(US)**
Inventor: **Masia, Michael**
**258, Grad Street**
**Redwood City California 94062(US)**

(74) Representative: **Benson, John Everett et al**
**Raychem Limited Intellectual Property Law Department Faraday Road Dorcan**
**Swindon, Wiltshire SN3 5HH(GB)**

EP 0 250 776 B1

Rank Xerox (UK) Business Services

# Description

This invention relates to methods and apparatus for detecting and obtaining information about (particularly locating) changes in variables.

A number of methods have been proposed for detecting and locating changes in variables along an elongate path, eg. the occurrence of a leak (of water or another liquid or gas), insufficient or excessive pressure, too high or too low a temperature, the presence or absence of light or another form of electro-magnetic radiation, or a change in the physical position of a movable member, eg. a valve in a chemical process plant or a window in a building fitted with a burglar alarm system. Changes of this kind are referred to in this specification by the generic term "event". Reference may be made for example to US Patents Nos. 1,084,910. 2,581,213, 3,248,646, 3,384,493, 3,800,216, and 3,991,413, UK Patent No. 1,481,850 and German Offenlegungschriften Nos. 3,001,150,0 and 3,225,742. However, the known methods are expensive, and/or inaccurate, and/or have a sensitivity which is dependent on the location of the event along the elongate path, and/or cannot be used when the event causes electrical connection between two conductors through a connection which is of high or indeterminate resistance, eg. an ionically conductive connecting element.

AT-A-58704 discloses a circuit arrangement for localizing faults in cables and wiring with the aid of a voltage drop method. On detecting a voltage drop along a length of wire, a voltmeter is adjusted by means of a variable resistor to calibrate the voltmeter. Subsequent voltage drops indicate the position of a fault.

Attention is also directed to the parent patent No. EP-B1-0133748 published 15.03.89.

We have now discovered a simple and accurate method and apparatus for monitoring for the occurrence of an event, and for detecting and obtaining information about the event upon its occurrence (ie. as soon as it occurs or at some time after it has occurred). In this method, upon occurrence of the event, at least one electrical connection is made between an elongate source member and an elongate locating member of known impedance characteristics, the connection or connections being effective at a first point at which the event takes place (or whose location is defined by some other characteristic of the event). A current of known size is then driven through the electrical connection(s) and down the locating member to a second point whose location is known. The voltage drop between the first and second points is then measured and the location of the first point can then be determined.

When the occurrence of the event causes a single or very short connection to be made between the locating member and the source member, then the "first point" will be easily identified, since it is the only connection point. However, when the event results in connection at two or more spaced-apart locations and/or over a finite length of the locating member, the "first point", ie. the point whose location is determined from the measured voltage drop, is some intermediate point (which, if there are connections at two or more spaced-apart locations, may be at a location at which there is no connection between the locating and source members). It is for this reason that the connection to the locating member is referred to herein as being "effective" at the first point.

The invention overcomes one or more of the disadvantages of the known processes. For many uses, a particularly important advantage is that the information obtained can be independent of the location of the event along the elongate path and independent of the impedance of the connection to the locating member, ie. the information obtained remains the same even if a substantial and unknown change is made in the impedance of the connection.

In one aspect, the invention provides a method for monitoring for the occurrence of an event, and for detecting and obtaining information about the event upon its occurrence, which method comprises providing a system in which, upon occurrence of the event,

(1) electrical connection (E) is made between (i) an elongate electrically conductive locating member (11) that has a total impedance $z_{total}$ between the ends thereof, and (ii) an elongate electrically conductive source member (12);

the connection to the locating member being effective at a first point (1) on the locating member whose location is defined by at least one characteristic of the event;

the making of the connection enabling the formation of a test circuit which comprises (a) the connection (E), (b) that part of the locating member (11) which lies between the first point (1) and a second point (2) having a known location on the locating member, (c) a part of the source member (12), and (d) a power source (15) which causes an electrical current of known size to be transmitted between the first and second points on the locating member, wherein the test circuit includes a balancing component which

(i) is connected in series with that part of the locating member between the first point (1) and the second point (2), and

(ii) has an impedance substantially equal to the difference between $z_{total}$ and the impedance of that part of the locating member which lies between the first point and the second point, and thus ensures that the impedance of the test circuit does not vary with the location of the connection (E); and

the current and the locating member being such that, by measuring the voltage drop between the first and second points, the spatial relationship between the first and second points can be determined;

(2) the voltage drop between the first and second points is measured; and

(3) information concerning the event is obtained from the measurement made in step (2).

In another aspect, the invention provides an event-sensitive module which is suitable for use in the method just defined and which comprises

(1) a first impedant component (111) having substantial impedance;

(2) a first conductor (112) which has a relatively very small impedance and one end of which is connected to the first impedant component;

(3) a second impedant component (121) having the same impedance as the first impedant component;

(4) a second conductor (122) which has a relatively very small impedance and one end of which is connected to the second impedant component; the first impedant component and the first conductor, in the absence of an event, being electrically insulated from the second conductor and the second impedant component; and

(5) an event-sensitive connection means (5) which, upon occurrence of an event, can effect electrical connection between the first and second conductors;

the first impedant component and the first conductor being connectable in series with incoming and outgoing portions of intermediate components of the elongate locating member (11), and the second impedant component and the second conductor being connectable in series with incoming and outgoing portions of intermediate components of the elongate source member (12).

## BRIEF DESCRIPTION OF THE DRAWING

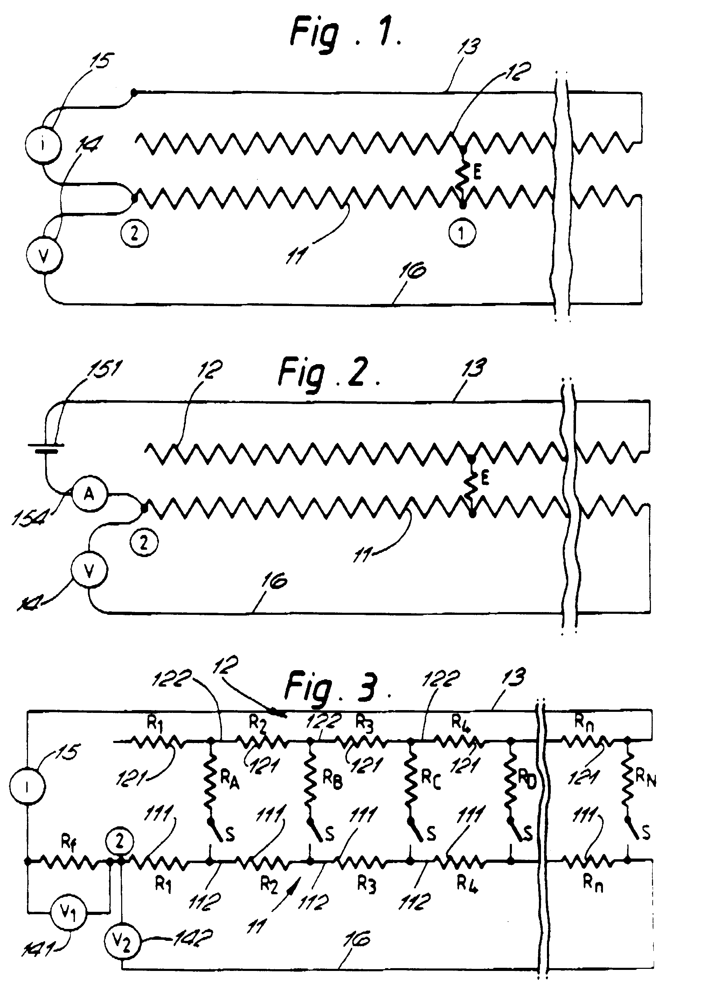

The invention is illustrated in the accompanying drawing, in which Figures 1-6 are schematic circuit diagrams of the method and apparatus of the invention.

## DETAILED DESCRIPTION OF THE INVENTION

In the interests of clarity, the following detailed description of the invention includes sections which are chiefly or exclusively concerned with a particular part of the invention. It is to be understood, however, that the relationship between different parts of the invention is of significant importance, and the following detailed description should be read in the light of that understanding. It should also be understood that, where features of the invention are described in the context of particular Figures of the drawing, the same description can also be applied to the invention in general and to the other Figures, insofar as the context permits.

## 1. THE ELECTRICAL CHARACTERISTICS OF THE INVENTION

The basic electrical characteristics of the invention can best be understood by reference to Figure 1, which schematically represents a substantial number of the preferred methods of the invention. In Figure 1, there is an elongate locating member 11, an elongate source member 12, an elongate auxiliary connection member 13, a voltage-measuring device 14, a power source 15 and an elongate return member 16. The source member is electrically connected, through the power source, to one end of the locating member; in the absence of an event, there is no other electrical connection between the locating member and the source member. Between the source end locating members (but not shown in Figure 1) is an event-sensitive connection means (this term being used to include a continuous event-sensitive connection means and a plurality of spaced-apart event-sensitive connection means) which becomes conductive at any location at which an event takes place. In Figure 1, an event has taken place at a first point 1 which lies on the locating member, and as a result of the event, an electrical connection E has been made between the locating and source members. The power source 15 is connected to the locating member at one end thereof, designated by the numeral 2, which is the "second point" in the definitions given above of the method of the invention.

(The second point could be at any point of known location between the end of locating member 11 and the connection point 1, providing that the voltage-measuring device is arranged to measure the voltage drop between the first and second points.) The making of the connection at point 1 results in the formation of a test circuit which includes the connection, the locating member between points 1 and 2, the power source 15, the auxiliary connection member 13, and part of the source member 12. As will be further discussed below, the only variable in the impedance of the test circuit is the impedance of the connection between the source and locating members. This result can conveniently be achieved by making use of a source member which has the same impedance characteristics as the locating member, and an auxiliary member which is connected to the source member only at the end thereof which is remote from point 2.

The voltage-measuring device is connected to the second point 2 on the locating member and (via the return member 16) to the opposite end of the locating member. Thus the voltage-measuring device forms part of a reference circuit which comprises the device 14, at least that part of the locating member 11 between points 1 and 2, and the return member 16.

It will be seen that the location of point 1 can be calculated if the following are known:-

(a) the current flowing between points 1 and 2,

(b) the impedance of the components of the reference circuit,

(c) the voltage drop measured by the voltage-measuring device,

(d) the location of point 2, and

(e) the impedance of the locating member between. point 2 and each point on the locating member.

Systems in which these features are known can be provided in a number of different ways. The accuracy with which the first point can be located is limited by the ratio of the impedance of the voltage-measuring device to any unknown part of the impedance of the other components of the reference circuit, and in most cases it is convenient to use components such that the ratio of the impedance of the device to the total impedance of the rest of the reference circuit is very high. Accordingly, these ratios should preferably be at least 100, particularly at least 1,000, especially at least 10,000.

By contrast, the impedance of the connection between the locating and source members, and the impedance of the other components of the test circuit, do not affect the accuracy of the information obtained; this is an important advantage of the invention.

## 2. INFORMATION WHICH CAN BE PROVIDED ABOUT AN EVENT

The method of the invention not only detects that a particular event has taken place, but also provides information about the event. In many cases, the information provided about the event is its location, particularly when the event takes place at (or near) the location of the first point. However, the information provided can be other information; for example when the temperature at a particular location is being monitored, one point on the locating member can be identified when the temperature is in one temperature range and another point can be identified when the temperature is in a different temperature range. As just noted, the location of the event may be at, or close to, the first point on the locating member. However, this is not necessarily so; for example, one or more remote event-detecting stations can be connected, electrically or otherwise, to different points on a central locating member, the locations of the connection points being characteristic of the locations of the event-detecting stations. The method of the invention will provide some, but not necessarily all, the desired information about the event. For example, the method can usefully be employed to determine that a given event (e.g. the opening of a valve) has taken place at one or more of a relatively small number of different locations, out of a relatively large number of possible locations for the event, leaving it to visual inspection or some other form of test (which may be a further and different method of the invention) to determine precisely where the event has taken place.

## 3. EVENTS WHICH CAN BE DETECTED, AND EVENT-SENSITIVE CONNECTION MEANS FOR DETECTING THEM

The event which is detected in the method of the invention can be an event which is not desired (a fault) or an event which is desired. The event can be the existence of a particular condition or a change in a single variable, e.g. an increase in pressure above a particular value, or a simultaneous or sequential change in two or more variables, e.g. an increase in pressure accompanied by an increase in temperature. The event can be a change in a variable which lasts for only a very short time, or a change in a variable which is maintained for some minimum time. The event can be of any kind which directly or indirectly permits or causes the current to be transmitted between the first point and the second point on the locating member. As noted above, the information obtained is independent of the impedance of the connection. Thus the connection between the locating and source members can be of any kind, for example an electronic connection (which can be of substantially zero impedance or can have substantial impedance), or an ionic connection resulting from the presence of an electrolyte, or an inductive connection. The change which takes place in order to effect the connection between the locating and source conductors is preferably a reversible change. However, the invention is also useful when the change is a permanent one, so that the apparatus must be replaced or repaired before the system is operational again. The system can be arranged so that it signals an event only while the event is taking place or so that it signals that an event has occurred in the past; in the latter case, the system will normally be arranged so that it can be reset.

Examples of events which can be detected include, but are not limited to, the following.

A. The presence of water or another electrolyte which provides an ionic connection between exposed surfaces of the locating and source members, especially when at least part of at least one of these comprises a metal core surrounded by a conductive polymer. In this case, the event-sensitive connection means can be merely a space between the locating and source members, or it can be a connection member on which the electrolyte collects or which absorbs the electrolyte.

B. The existence of a temperature which is below a first temperature $T_1$ or above a second temperature $T_2$. In one apparatus for detecting such a condition, the locating and source members are physically contacted by a connecting member which insulates them from each other at $T_1$ and connects them to each other at $T_2$. For example, at least part of the connecting member can comprise (a) a first material and (b) a second material which is dispersed in the first material and which forms mobile ionic species when the temperature changes from $T_1$ to $T_2$. Thus the first material can be one which changes phase, e.g. melts, when the temperature changes from $T_1$ to $T_2$.

In another apparatus for detecting a temperature change, the locating and source members are separated from each other by a deformable insulating medium, e.g. an insulating medium which is at least in part a fluid, e.g. air, and the apparatus comprises a connecting member which changes shape when the temperature changes from $T_1$ to $T_2$, thus forcing the members into contact, by deforming the insulating medium, or, if the connecting member is itself conductive, by forcing the connecting member through the insulating medium to connect the members. The connecting member can comprise a heat-recoverable polymer or a heat-recoverable memory metal or can comprise a bimetallic strip. The term "memory metal" is used herein to denote one of the metal alloys (in particular various brass alloys and nickel-titanium Alloys) which exist in a strong austenitic state above a transformation temperature and in a weak martensitic state below that transformation temperature, and which, if fabricated in a first shape in the austenitic state, can be cooled to the martensitic state and then deformed, will retain the deformed configuration until reheated to the austenitic state, when they will revert (or attempt to revert) towards the original shape. Where a reversible effect is desired, a particular type of memory metal must be employed or the memory metal member can be combined with a conventional spring metal member to produce a connecting member which will connect the locating and source members either when the temperature rises above the transformation temperature or when it falls below the transformation temperature (as more specifically discussed below, in connection with the Figures). For further details of memory metals and devices comprising them, reference may be made for example to U.S. Patents Nos. 3,174,851, 3,740,839, 3,753,700, 4,036,669, 4,144,104, 4,146,392, 4,166,739 and 4,337,090.

C. A change in the concentration of a particular substance, which may for example be a gas, a liquid or a solid dispersed in a gas or a liquid, the locating and source members being physically contacted by a connecting member which insulates them prior to said change, and which electrically connects them as a result of said change. The electrical connection can for example result from a chemical reaction between the substance and at least part of the connecting member, thus for example releasing a mobile ionic species. Alternatively, the presence of the substance can for example cause at least port of the connecting member to change shape, as for example where the substance causes swelling of a conductive polymer connecting member or where the substance is a solvent for an adhesive or polymeric retaining member which maintains a spring member in a deformed state, or can change the state of an ionization chamber, for example in a smoke detector, or the transmissivity of a photoelectric cell, which in turn will cause a switch to connect the locating and return members.

D. A change from a first pressure $P_1$, to a second pressure, $P_2$, the locating and source members being contacted by a connecting member which insulates them from each other at pressure $P_1$ but permits electrical connection between them at pressure $P_2$. For example, the connecting member can be deformable, e.g. composed of air or other fluid insulating material.

E. A change in the intensity or other characteristic of electromagnetic radiation, the locating and source members being physically contacted by a connecting member which is exposed to said radiation, which insulates them from each other prior to said change and which electrically connects them to each other after said change. Suitable apparatus could for example include a photoelectric cell.

F. A change in the position of a valve, e.g. in a refinery or other chemical process plant, thus changing the position of a switch in a connecting member between the locating and source members.

## (4) SETTING A MAXIMUM FOR THE IMPEDANCE OF THE CONNECTION BETWEEN THE SOURCE AND LOCATING MEMBERS

In some situations, it is desirable that the system should not signal an event when the connection between the source and locating members has an impedance over some preselected value, for example when the presence of a small amount of electrolyte makes a very high resistance connection. In these situations, the system is preferably such that when the current in the test circuit is below a preselected value, the occurrence of an event is not signalled.

This is particularly important when, as is preferred, the power source is a fixed current source, since the voltmeter may otherwise provide a false indication of the location of the event. This is because the fixed current source will only provide the expected fixed current if the compliance voltage of the power source is high enough to drive the fixed current through the test circuit. Therefore, if the impedance of the test circuit is too high, the actual current in the test circuit will be less than the "fixed" current, and the voltage drop between the first and second points on the locating member will not correctly represent the location of the first point. actual current in the test circuit will be less than the "fixed" current, and the voltage drop between the first and second points on the locating member will not correctly represent the location of the first point. This difficulty can be avoided by blanking out the display on (or associated with) the voltmeter if the current is below the fixed value or by including in the test circuit a current switch which will prevent currents below the "fixed" current from flowing in the test circuit.

Even when the information provided about the event is correct, delivery of that information may be undesirable. Under these circumstances, when using a constant current source, the output voltage of the source can be monitored, and delivery of information prevented unless the output voltage is within a predetermined range. Similarly, when using a constant voltage source, the current in the test circuit can be monitored, and delivery of information prevented (for example by use of a current switch or by blanking out the display on, or associated with, the voltmeter) unless the current is within a predetermined range.

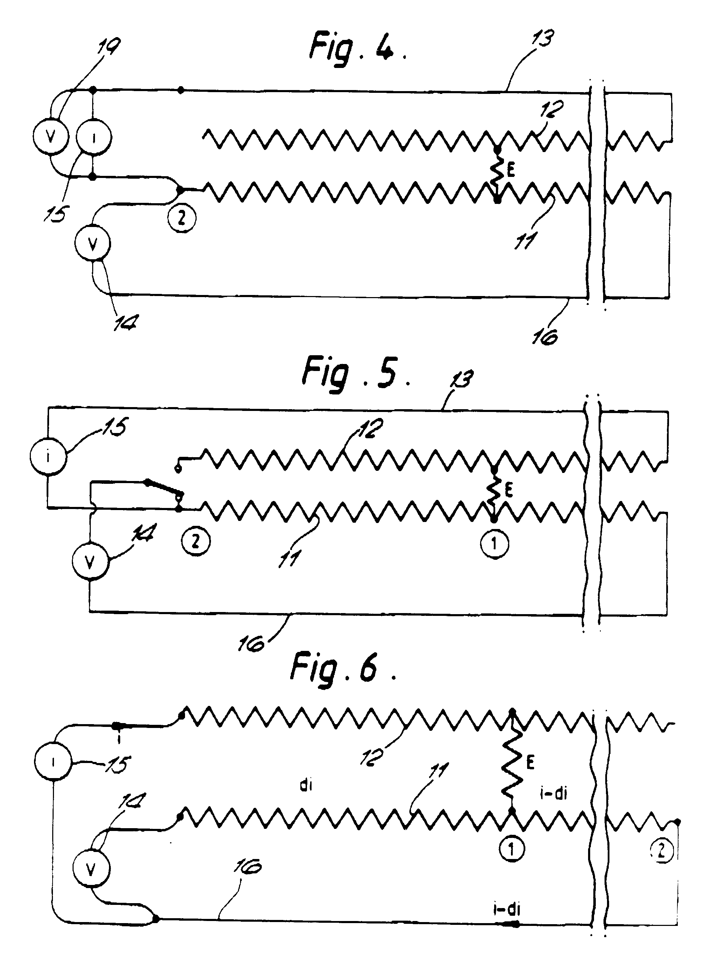

In a system of this kind, the critical parameter (in determining whether or not the information is delivered) is the impedance of the test circuit, and it is, therefore, desirable that the only variable impedance in the test circuit should be the impedance of the connection. It is an important advantage of the present invention that this is achieved through the use of a balancing component which (1) is connected in series with that part of the locating member which lies between the first and second points, and (2) has an impedance substantially equal to the difference between the total impedance of the locating member and the impedance of that part of the locating member which lies between the first and second points. Such a component is preferably provided by making use of a source member which has the same impedance characteristics as the locating member, and by ensuring that the test circuit includes complementary portions of the source and locating members which, taken together, have the same impedance wherever the connection is made. This can be done by including an auxiliary member which is connected to the end of the source member which is remote from the second point (as shown in Figure 1) or by making the return member form part of the test circuit (as shown in Figure 6). By including such a balancing component, the sensitivity of the system is made the same throughout its length. In the absence of such a component, the impedance of the locating member (between the first and second points) will also be a variable, and it will not be possible to fix precisely the range of impedances of the connection which will cause an event to be signalled.

The sensitivity of such systems can easily be changed (for example so that leaks of different minimum sizes are signalled). When using a fixed current source, sensitivity can be changed by changing the compliance voltage of the source and/or by including a known impedance in the test circuit, and/or by changing the preselected range of output voltages. When using a fixed voltage source, the size of the voltage can be changed, and/or a known impedance can be included in the test circuit, and/or the preselected current value can be changed.

## (5) MEASURING THE VOLTAGE DROP DOWN THE LOCATING MEMBER WITH THE AID OF A REFERENCE IMPEDANCE

When a "fixed" current source is used to provide a very low current, the current may very substantially (e.g. by about 4%) from the "fixed" value (even when the output voltage is less than the compliance voltage). Other factors may also cause the current in the test circuit to vary with time. Under these circumstances, preferably the test circuit includes a reference impedance which is connected in series with the locating member, and the location of the first point is calculated from the ratio of the voltage drop between the first and second points to the voltage drop over the reference impedance. In effect, this procedure measures the current in the test circuit by measuring the voltage drop over the reference impedance.

## (6) THE LOCATING MEMBER

The locating member is an elongate member, this term being used to denote a member having a length which is substantially greater, e.g. at least 100 times greater, often at least 1,000 times greater, sometimes at least 10,000 times greater or even at least 100,000 times greater, than either of its other dimensions. However, the locating member can also be in the form of a sheet or some other more complex shape.

The locating member preferably has sufficient impedance to cause a voltage drop which is easily and accurately measured. Preferably, therefore, it has a resistance which averages at least 0.1 ohm/ft (0.33 ohm/m), particularly at least 1 ohm/ft (3.3 ohm/m), e.g. 1 to 5 ohm/foot (3.3 to 16.5 ohm/m). On the other hand, its resistance should preferably not be too high and preferably averages less than $10^4$ ohm/foot ($3.3 \times 10^4$ ohm/m), particularly less than $10^2$ ohm/foot ($3.3 \times 10^2$ ohm/m), especially less than 20 ohm/foot (65.5 ohm/m). A key feature of the present invention is that, under the conditions of operation, the impedance of the locating member is dependent substantially only on the distance between the first and second points. This is essential because it is not otherwise possible to calculate the location of the first point from the change in voltage measured by the voltage-measuring device. The locating member may be of constant cross-section along its length so that its resistance per unit length is constant and the voltage change is directly proportional to the distance between the first and second points. However, this is not essential, providing that the impedance changes in a known fashion along the length of the member, so that the voltage change and the distance can be correlated. Thus under some circumstances, considerable advantages may result from the use of a locating member which comprises a plurality of spaced-apart impedances which are connected by intermediate elongate components of low impedance.

The most common variable affecting the resistivity (and, therefore, resistance) of the locating member is temperature. Many materials, and in particular copper and other metals most commonly used for electrical conductors, have a resistivity which changes with temperature to an extent which, although unimportant for many purposes, can result in unacceptable margins of error in locating the first point under conditions in which the temperature can vary substantially and unpredictably along the length of the locating member. It is preferred, therefore, that the locating member should have a temperature coefficient of impedance (usually resistance) which averages less than 0.003, particularly less than 0.0003, especially less than 0.00003, per degree Centigrade over at least one 25° temperature range between -100°C and +500°C, and preferably over the temperature range 0° to 100°C, especially over the temperature range 0° to 200°C. For a simple metal conductor, the temperature coefficient of impedance is the same as the temperature coefficient of resistivity. The value for copper is about 0.007 per deg C. Metals having lower temperature coefficients of resistivity are well known and include Constantan (also known as Eureka), Manganin and Copel, and others listed for example in the International Critical Tables, published 1929 by McGraw-Hill Book Co., Vol. VI, pages 156-170.

It is of course important that the locating, source and return members should be sufficiently strong, and should be assembled in such a way, that they can withstand the stresses on them during installation and use. For the return member this usually presents no problem, because it can be and preferably is securely enclosed in a conventional polymeric insulating jacket. However, electrical contact is necessary at intermediate points of the locating and source members, and can be necessary at intermediate points of the return member also. This can result in problems, particularly when one or more of the members is a wire of relatively small cross-section. However, we have found that in many applications of the invention, especially those in which the event is the presence of an electrolyte, an excellent combination of desired properties can be obtained through the use of a locating member and/or a source member comprising a metal core and an elongate jacket which electrically surrounds the core and which is composed of a conductive polymer. The term "electrically surrounds" is used herein to mean that all electrical paths to the core (intermediate the ends thereof) pass through the jacket. Normally the conductive polymer will completely surround the core, being applied for example by a melt-extrusion process; however it is also possible to make use of a jacket which has alternate insulating sections and conductive sections.

The term "conductive polymer" is used herein to denote a composition which comprises a polymeric component (e.g. a thermoplastic or an elastomer or a mixture of two or more such polymers) and, dispersed in the polymeric component, a particulate conductive filler (e.g. carbon black, graphite, a metal powder or two or more of these). Conductive polymers are well known and are described, together with a variety of uses for them, in for example U.S. Patents Nos. 2,952,761, 2,978,665, 3,243,753, 3,351,882, 3,571,777, 3,757,086, 3,793,716, 3,823,217, 3,858,144, 3,861,029, 4,017,715, 4,072,848, 4,117,312, 4,177,446, 4,188,276, 4,237,441, 4,242,573, 4,246,468, 4,250,400, 4,255,698, 4,271,350, 4,272,471, 4,304,987, 4,309,596, 4,309,597, 4,314,230, 4,315,237, 4,317,027, 4,318,881 and 4,330,704; J. Applied Polymer Science 19 813-815 (1975), Klason and Kubat; Polymer Engineering and Science 18, 649-653 (1978), Narkis et al; German OLS 2,634,999; 2,755,077; 2,746,602; 2,755,076; 2,821,799; European Application No. 38,718; 38,715, 38,718, 38,713, 38,714, 38,716;and U.K. Application No. 2,076,106A.

The resistivity of conductive polymers usually changes with temperature at a rate well above the preferred temperature coefficient of resistivity set out above, and the PTC conductive polymers often increase in resistivity by a factor of 10 or more over a 100°C range. Accordingly it is important that in a locating member comprising a conductive polymer jacket, at all temperatures likely to be encountered, e.g. at all temperatures from 0° to 100°C, each longitudinal section of the conductive polymer jacket has a resistance which is at least 100 times, preferably at least 1000 times, the resistance of the core of that longitudinal section. In this way (since the core and the jacket are connected in parallel), the jacket does not make any substantial contribution to the resistance of the elongate conductor, and any change in its resistance with temperature is unimportant.

The second point on the locating member must have a known location, and it is normally a fixed point. When the system is designed to detect different types of events occurring independently, the second point is preferably the same fixed point for detection of the different events.

The second point will normally be at one end or the other of the locating member. However, the invention includes, for example, the simultaneous or sequential use of a plurality of second points to determine the locations of a plurality of first points when a number of different events having identified a number of first points.

## (7) THE SOURCE MEMBER

The source member is preferably substantially identical to, and follows the same general path as,the locating member.

## (8) THE RETURN MEMBER

In many cases, the return member also has the same general configuration and follows the same general path as the locating member. This is preferred when the return member is electrically connected to the locating member at the ends thereof but is otherwise insulated therefrom. On the other hand it is not necessary when the locating and source members follow a path in the form of a loop, since the return member can then be a relatively short member which joins (via the voltage-measuring device) the two ends of the locating member. The return member will usually follow the same general path as the source and locating members in another embodiment in which, when an event occurs, not only is a connection made between the locating and source members, but also an electrical connection of known resistance is made between the return member and the locating member at the first point or at some other point on the locating member which is further away from the second point. The return member preferably has substantially no reactance and can conveniently be a simple insulated wire whose resistance per unit length is sufficiently low for the resistance of the return member to be ignored in obtaining the desired information about the event, e.g. less than 0.01 times the resistance per unit length of the locating member.

## (9) ASSEMBLY OF THE ELONGATE CONNECTION MEMBERS

The source and locating members, usually the return member, the auxiliary member when present, and any other elongate members which may be desired (e.g. for checking continuity or to provide physical strength) can be combined together in any convenient way to provide a cable which can be positioned along the desired elongate path. If desired the return member, or the locating member, or a further member, can be relatively large and strong, and thus be a strength member to which the other members are secured, e.g. by wrapping, preferably in the form of a braid which may include additional elongate members.

## (10) USE OF SUBSTANTIALLY IDENTICAL LOCATING AND SOURCE MEMBERS

Very valuable improvements can be obtained through the use of a locating member which has impedance characteristics such that, and which is connected so that, the only variable impedance in the test circuit is the impedance of the connection which is created by the occurrence of the event. As noted above, this makes it possible to design a system which, at all points along its length, will be sensitive only to events which create a connection whose impedance is within a predetermined range. Another important advantage is that the impedance of the connection itself can be measured. This can be done, for example,

(a) when a constant current source is used, by measuring the output voltage;

(b) when a constant voltage source is used, by measuring the current in the test circuit; or

(c) by including a switching arrangement so that, after the location of the event has been determined, a new circuit is created in which the voltage measured by the voltmeter is a measure of the impedance of the event.

When the locating member includes a plurality of spaced-apart impedant components, the source member preferably comprises corresponding spaced-apart impedant components. In order to make up such a system it is convenient to use pre-assembled modules which can be connected into the locating and source members to provide impedant components in those members and an event-sensitive connection member to connect those members when an event takes place. Such modules are novel and form the second aspect of the present invention, as defined above. Preferably the module also comprises a third impedant component connected to the other end of the first conductor, and a fourth impedant component connected to the other end of the second conductor, the third and fourth components having the same impedance as the first and second components. When using such a preferred module it does not matter whether the incoming portion of the locating member is connected to the first component and the outgoing portion of the locating member is connected to the third component, or vice versa. Similarly it does not matter whether the incoming portion of the source member is connected to the second component and the outgoing portion of the source member is connected to the fourth component, or vice versa. This reduces the danger of incorrect installation of the system. Indeed, if the event-sensitive connection means operates in the same way whichever the direction of the current through it, it does not matter how the intermediate portions of the source and locating members are connected to the module, provided that the locating member is connected through one of the conductors and the source member is connected through the other conductor.

The module will often comprise a support member to which components (1) to (5) are secured; and/or a housing which provides physical and/or electrical protection for the components; and/or terminals for connecting the module as indicated above.

## (11) THE POWER SUPPLY

The current which is transmitted between the first and second points must be of known size, and is preferably supplied by a controlled current source, e.g. a galvanostat; however, a controlled voltage source can be used providing that a current-measuring device is included in the apparatus so that the location of the first point can be calculated. The current may be a continuous or pulsed direct current or an alternating current of regular sinusoidal or other form. The current which flows between the first and second points is often in the range of 0.05 to 100 milliamps, particularly 0.1 to 10 milliamps, e.g. 0.5 to 3 milliamps. However, where very long paths are to be monitored for events, even lower currents can be employed, especially when using a reference impedance, as described above.

The controlled current source is preferably a fixed current source or a current source which can be adjusted to provide current of a desired and known value, for example to obtain improved accuracy in locating a fault which was detected at a lower current level. However, it is also possible to use a fixed voltage source, in combination with a current-measuring device which measures the current flowing between the first and second points. The power source is preferably connected to the locating member at the second point at all times. In the absence of an event, it may be otherwise insulated from the locating member.

## (12) THE VOLTAGE-MEASURING DEVICE

The voltage-measuring device can be of any kind, and suitable devices are well known to those skilled in the art. Preferably the voltage-measuring device is a voltmeter which has a resistance of at least 10,000 ohms, preferably at least 1 megohm, especially at least 10 megohms.

## (13) PHYSICAL AND ELECTRICAL RELATIONSHIPS BETWEEN THE COMPONENTS OF THE APPARATUS

As briefly indicated in the description of Figure 1, the physical and electrical relationships between the components of the apparatus of the invention can be widely varied. Figures 2-6 show a number of different arrangements which are specific variants of the circuit generically illustrated in Figure 1

In each of Figures 2-6, there is a power source 15, a voltage-measuring device 14, a locating member 11, a source member 12 and a return member 16. The locating member is shown as a resistor because it must have appreciable resistance in order for the voltage drop down it to be large enough to permit accurate location of the point 1, at which the source member is connected to the locating member. The source member is a resistive member identical to the locating member in other Figures. The return member is shown as a simple low resistance conductor, which it preferably is, but the return member can have substantial resistance, providing that it is a known resistance.

In Figure 3, there are shown switches, S. Any other means can be employed, in addition so simple switches making a zero resistance electronic contact, in the test circuit, and any other means providing a connection of known resistance can be used in the reference circuit. In most of the Figures, the power source is shown as a controlled current source, but in Figure 2, the power source is a battery and the test circuit includes an ammeter 154.

Some of the different possible relationships between the components will now be enumerated, using the Figures as examples of these relationships where appropriate.

(A) The power source can be positioned near the second point on the locating member, as illustrated in Figures 1-5, or near the end of the locating member which is remote from the second point, as illustrated in Figure 6 In most cases, the power source and the voltage-measuring device are positioned near to each other as illustrated in each of the Figures.

(B) The apparatus can include one or more switches, which may be ganged together or may operate independently, to provide for switching the connections between the locating member and the power source from a first arrangement in which the second point is at one end of the locating member to a second arrangement in which the second point is at the opposite end of the locating member thus making it possible first to measure the distance from one end that an event has taken place and then to measure the distance from the other end that an event has taken place.

(C) It is also possible for the apparatus to be one in which occurrence of the event causes not only connection between the source and locating members, but also connection between the return and locating members.

The making of the connection between the locating and return members can be the direct result of the making of the connection between the locating and source members, e.g. by means of a ganged switch, or the condition which causes one connection to be mode can also cause the other connection to be made.

Alternatively, the connection between the locating and return members can result from the existence of a condition which is different from the condition which effects connection between the locating and source members.

(D) The event can comprise the existence of a particular condition at each of a plurality of spaced-apart locations, the connection between the locating member and the source member being made through an event-sensitive connection member comprising a plurality of condition-sensitive members which are electrically connected in series, which are respectively located at each of said spaced-apart locations, and each of which is electrically conductive when said condition exists at its location and is not electrically conductive when said condition does not exist at its location.

(E) The event can comprise the existence of a particular condition at at least one of a plurality of spaced-apart locations, the connection between the locating member and the source member being made through an event-sensitive connection member comprising a plurality of condition-sensitive members which are electrically connected in parallel, which are respectively located at each of said spaced-apart locations, and each of which is electrically conductive when said condition exists at its location and is not electrically conductive when said condition does not exist at its location.

(F) The event can comprise the existence of a first condition at a first location and the existence of a second condition at a second location (which may be immediately adjacent the first location), the connection between the locating member and the source member being made through an event-sensitive member comprising (a) a first-condition-sensitive member which is at the first location and which is electrically conductive when the first condition exists at the first location and is not electrically conductive when the first condition does not exist at the first location and (b) a second-condition-sensitive member which is at the second location, which is electrically conductive when the second condition exists at the second location and is not electrically conductive when the second condition does not exist at the second location, and which is electrically connected in series with the first-condition-sensitive member.

(G) The event can comprise the existence of a first condition at a first location or the existence of a second condition at a second location, (which may be immediately adjacent the first location), the connection between the locating member and the source member being made through an event-sensitive member comprising (a) a first-condition-sensitive member which is at the first location and which is electrically conductive when the first condition exists at the first location and is not electrically conductive when the first condition does not exist at the first location and (b) a second-condition-sensitive member which is at the second location, which is electrically conductive when the second condition exists at the second location and is not electrically conductive when the second condition does not exist at the second location, and which is electrically connected in parallel with the first-condition-sensitive member.

(H) It is also possible for the system to include two or more source members, which become respectively connected to the locating member when a particular condition (different for each source member) exists. In this case the event is the existence of one of those two (or more) conditions at any point along the elongate path followed by the locating and source members. The system can also include switches such that it is possible to disconnect all but one of the source members, and thus to determine which of the particular conditions exists.

(I) It is also possible for the system to include at least one auxiliary source member which is connected to the power source and which becomes connected to the source member (or to another auxiliary source member) when a particular second condition exists, the second condition being different from the first condition which causes the source member to become connected to the locating member. In this case, the event is the existence, at any one or more points along the path, of a second condition which causes the auxiliary source member to become connected to the source member, and the existence, at one or more points along the path, of a first condition which causes the source and locating members to become connected.

(J) It is also possible for the system to include at least one auxiliary return member which is connected to the voltage-measuring device and which becomes connected to the return member when a second condition exists, the second condition being different from the first condition which causes the source and locating members to become connected. The return member can be connected to the end of the locating member which is remote from the second point, in which case the event is the existence of the first condition at one or more points along the path and the existence of the second condition at one or more points along the path, with the information provided being the location of the first condition which is nearest to the second point. Alternatively, the return member can become connected to the locating member as the result of a third condition.

(K) It is also possible for the apparatus to follow an elongate path in the form of a loop, so that the return member need not follow the elongate path but can simply join, via the voltage-measuring device, the two ends of the locating member.

(L) It is also possible for a plurality of event-detecting stations (which can detect the same or different events) to be positioned at locations which are remote from the locating member and to be electrically (or otherwise) connected to switches (e.g. electromagnetically operated relays) between the locating and source members.

(M) It is also possible, when event-detection is required only in spaced-apart zones, for the locating member to comprise (a) a plurality of spaced-apart elongate locating components, each of which provides a series of points to which the connection can be made and preferably has a relatively high resistance per unit length, and (b) a plurality of spaced-apart elongate intermediate components which physically separate and electrically connect the locating components, which cannot become directly connected to the source member and which preferably have a relatively low resistance. This system might be used for example when detection and location were needed within each of a plurality of houses separated from each other along a street, but not between the houses.

(N) The method can also be used to locate events along a branched path. However, when using such a branched system, if the voltage-measuring device shows an event at a distance beyond the first branching point, then there are often two or more possible locations for the fault. If desired, the location can be precisely identified by connecting the controlled current source and voltmeter to the conductors at the branch point(s) (preferably via low resistance drop leads installed at the same time as the detection system). (This expedient can also be used in unbranched systems in order to provide improved accuracy of location of the event, after the general vicinity of the event has been indicated.) Alternatively, AC current sources of different frequencies can be employed sequentially and filters can be placed in the different branches so that only one branch is being tested at any one time. of the event, after the general vicinity of the event has been indicated.) Alternatively, AC current sources of different frequencies can be employed sequentially and filters can be placed in the different branches so that only one branch is being tested at any one time.

(O) It is preferred as shown for example in each of the Figures, for the source member to have the same impedance characteristics as the locating member, and to be connected so that the only variable impedance in the tent circuit is the impedance of the connection, Figures 1, 2, and 4-6 show the locating and source members as continuous resistors of constant resistance per unit length. Figure 3 shows the locating and source members comprising a plurality of resistors 111 (in the locating member) and 121 (in the source member), which can have the same or different resistances $R_1$ to $R_m$, and a plurality of low resistance intermediate components 112 and 122. The event connections E in Figures 1, 2, and 4-6 are shown as resistors of indeterminate size. In Figure 3 the event connection is made by closing one or more of the switches S, which have in series with them resistors $R_A$ to $R_N$ which can be the same or different.

Figure 3 also shows a reference resistor $R_f$ connected in series with the locating member, and a voltmeter 141 which measures the voltage drop over the reference resistor, so that the location of the connection can be calculated from the ratio of the voltage drops measured by the two voltmeters.

Figure 4 includes a second voltmeter 19 whch measures the output voltage of the power source. The impedance of the connection E can be calculated from the output voltage (so long as the power source is delivering the desired "fixed" current).

Figure 5 incorporates a switch 161 such that the return member can be connected as shown or can be disconnected from the near end of the locating member and connected to the near end of the source member. In the latter configuration, the voltage measured by the voltmeter is a measure of the impedance of the connection E.

## (14) VOLTAGE DROP VS. DISTANCE

The relationship between the voltage drop measured by the voltage-measuring device and the distance between the first and second points will depend on the way in which the apparatus is designed. When connection can be made to the locating member at any point along its length, and the locating member is of uniform impedance along its length, then the relationship will be a straight line of uniform slope.

When the event-sensitive connection means is discontinuous, so that connection to the locating member is possible only at spaced-apart points, then the relationship will be a series of points.

When the locating member is divided into locating and connection zones and can be contacted at any point within a locating zone, then the relationship is as shown in Figure 32.

## (15) PARTICULAR EVENT-SENSITIVE CONNECTION MEANS

Particular event-sensitive connection means which can be used in this invention are disclosed in the parent patent No. EP-B1-0133748.

## Claims

1. A method for monitoring for the occurrence of an event, and for detecting and obtaining information about the event upon its occurrence, which method comprises providing a system in which, upon occurrence of the event,

   (1) electrical connection (E) is made between (i) an elongate electrically conductive locating member (11) that has a total impedance $z_{total}$ between the ends thereof, and (ii) an elongate electrically conductive source member (12);

   the connection to the locating member being effective at a first point (1) on the locating member whose location is defined by at least one characteristic of the event;

   the making of the connection enabling the formation of a test circuit which comprises (a) the connection (E), (b) that part of the locating member (11) which lies between the first point (1) and a second point (2) having a known location on the locating member, (c) a part of the source member (12), and (d) a power source (15) which causes an electrical current of known size to be transmitted between the first and second points on the locating member, wherein the test circuit includes a balancing component which

   (i) is connected in series with that part of the locating member between the first point (1) and the second point (2), and
   (ii) has an impedance substantially equal to the difference between $z_{total}$ and the impedance of that part of the locating member which lies between the first point and the second point, and thus ensures that the impedance of the test circuit does not vary with the location of the connection (E); and the current and the locating member being such that, by measuring the voltage drop between the first and second points, the spatial relationship between the first and second points can be determined;

   (2) the voltage drop between the first and second points is measured; and
   (3) information concerning the event is obtained from the measurement made in step (2).

2. A method according to claim 1, wherein the source member (12) has substantially the same impedance characteristics as the locating member, and said balancing component is that part of the source member which is present in the test circuit.

3. A method according to claim 1 or 2 which comprises measuring the impedance of the connection (E) between the locating and source members.

4. A method according to any one of the preceding claims wherein the locating member comprises (1) a plurality of spaced-apart locating zones, each of said zones providing a series of points to which the connection can be made, and (2) a plurality of spaced-apart connection zones which physically separate and electrically connect the locating zones and which cannot become connected to the source member.

5. A method according to any one of the preceding claims wherein the power source (15) is a controlled current source which delivers a known fixed current.

6. A method according to any one of the preceding claims wherein the voltage drop between the first and second points is determined by means of a voltage-measuring device (14) which forms part of a reference circuit, the reference circuit comprising
    (a) the voltage-measuring device (14).
    (b) that part of the locating member which lies between the first and second points (1) and (2), and
    (c) an electrically conductive return member (16) which (i) is electrically connected to the locating member at the ends thereof, and (ii) is otherwise insulated from the locating member,
the voltage measuring device having an impedance which is very high by comparison with the impedance of the other components of the reference circuit.

7. A method according to any one of claims 2 to 4 wherein the test circuit includes a reference impedance ($R_f$) which is connected in series with the locating member, and wherein the location of the first point (1) on the locating member is calculated from the ratio of (i) the voltage drop between the first point (1) and the second point (2) on the locating member to (ii) the voltage drop over the reference impedance.

8. A method according to any one of the preceding claims wherein information concerning the event is obtained in step (3) only when the ratio V/I is within a predetermined range, wherein V is the output voltage of the power source and I is the current in the test circuit.

9. A method according to claim 8 wherein the power source (15) is a controlled current source which delivers current at a fixed value, and information is obtained in step (3) only when the current between the first and second points is substantially at said fixed value.

10. An event-sensitive module which is suitable for use as a component in a method as claimed in any one of the preceding claims, the module comprising
    (1) a first impedant component (111) having substantial impedance;
    (2) a first conductor (112) which has a relatively very small impedance and one end of which is connected to the first impedant component;
    (3) a second impedant component (121) having the same impedance as the first impedant component;
    (4) a second conductor (122) which has a relatively very small impedance and one end of which is connected to the second impedant component;

    the first impedant component and the first conductor, in the absence of an event, being electrically insulated from the second conductor and the second impedant component; and
    (5) an event-sensitive connection means (5) which, upon occurrence of an event, can effect electrical connection between the first and second conductors;
the first impedant component and the first conductor being connectable in series with incoming and outgoing portions of intermediate components of the elongate locating member (11), and the second impedant component and the second conductor being connectable in series with incoming and outgoing portions of intermediate components of the elongate source member (12).

11. A module according to claim 10, comprising a third impedant component connected to the other end of the first conductor, and a fourth impedant component connected to the other end of the second conductor, the third and fourth components having the same impedance as the first and second components.

## Revendications

1. Procédé pour déceler l'apparition d'un événement et pour détecter et obtenir une information concernant l'événement à la suite de son apparition, lequel procédé consiste à procurer un système dans lequel, à l'apparition de l'événement,

(1) une connexion électrique (E) est réalisée entre (i) un élément allongé (11) de localisation, électriquement conducteur, qui possède une impédance totale $Z_{total}$ entre ses extrémités, et (ii) un élément allongé (12) de source, électriquement conducteur ;

la connexion sur l'élément de localisation étant effective en un premier point (1) sur l'élément de localisation dont l'emplacement est défini par au moins une caractéristique de l'événement ;

la réalisation de la connexion permettant la formation d'un circuit de test qui comprend (a) la connexion (E), (b) la partie de l'élément de localisation (11) qui se trouve entre le premier point (1) et un second point (2) ayant un emplacement connu sur l'élément de localisation, (c) une partie de l'élément de source (12), et (d) une source d'énergie (15) qui provoque la transmission d'un courant électrique de valeur connue entre les premier et second points sur l'élément de localisation, le circuit de test comprenant un composant d'équilibrage qui

(i) est connecté en série avec la partie de l'élément de localisation située entre le premier point (1) et le second point (2), et

(ii) possède une impédance sensiblement égale à la différence entre $Z_{total}$ et l'impédance de la partie de l'élément de localisation qui se trouve entre le premier point et le second point, et assure donc que l'impédance du circuit de test ne varie pas avec l'emplacement de la connexion (E) ; et

le courant et l'élément de localisation étant tels qu'en mesurant la chute de tension entre les premier et second points, on peut déterminer la relation spatiale entre les premier et second points ;

(2) la chute de tension entre les premier et second points est mesurée ; et

(3) une information concernant l'événement est obtenue à partir de la mesure effectuée à l'étape (2).

2. Procédé selon la revendication 1, dans lequel l'élément de source (12) possède sensiblement les mêmes caractéristiques d'impédance que l'élément de localisation, et ledit composant d'équilibrage est la partie de l'élément de source qui est présente dans le circuit de test.

3. Procédé selon la revendication 1 ou 2, qui consiste à mesurer l'impédance de la connexion (E) entre les éléments de localisation et de source.

4. Procédé selon l'une quelconque des revendications précédentes, dans lequel l'élément de localisation comporte (1) plusieurs zones espacées de localisation, chacune desdites zones procurant une série de points sur lesquels la connexion peut être réalisée, et (2) plusieurs zones espacées de connexion qui séparent physiquement et connectent électriquement les zones de localisation et qui ne peuvent pas être connectées à l'élément de source.

5. Procédé selon l'une quelconque des revendications précédentes, dans lequel la source d'énergie (15) est une source de courant régulée qui délivre un courant fixe connu.

6. Procédé selon l'une quelconque des revendications précédentes, dans lequel la chute de tension entre les premier et second points est déterminée au moyen d'un dispositif (14) de mesure de tension qui fait partie d'un circuit de référence, le circuit de référence comportant

(a) le dispositif (14) de mesure de tension,

(b) la partie de l'élément de localisation qui se trouve entre les premier et second points (1) et (2), et

(c) un élément de retour (16) électriquement conducteur qui (i) est connecté électriquement à l'élément de localisation à ses extrémités, et (ii) est autrement isolé de l'élément de localisation,

le dispositif de mesure de tension ayant une impédance qui est très élevée en comparaison avec l'impédance des autres composants du circuit de référence.

7. Procédé selon l'une quelconque des revendications 2 à 4, dans lequel le circuit de test comprend une impédance de référence ($R_f$) qui est connectée en série avec l'élément de localisation, et dans lequel l'emplacement du premier point (1) sur l'élément de localisation est calculé d'après le rapport de (i) la chute de tension entre le premier point (1) et le second point (2) sur l'élément de localisation à (ii) la chute de tension sur l'impédance de référence.

8. Procédé selon l'une quelconque des revendications précédentes, dans lequel l'information concernant l'événement est obtenue dans l'étape (3) seulement lorsque le rapport V/I est dans une plage prédéterminée, où V est la tension de sortie de la source d'énergie et I est le courant dans le circuit de test.

9. Procédé selon la revendication 8, dans lequel la source d'énergie (15) est une source de courant régulée qui délivre un courant à une valeur fixe, et une information est obtenue à l'étape (3) seulement lorsque le courant entre les premier et second points est sensiblement à ladite valeur fixe.

10. Module sensible à un événement qui est apte à être utilisé en tant que composant dans un procédé selon l'une quelconque des revendications précédentes, le module comportant

(1) un premier composant à impédance (111) ayant une impédance substantielle ;

(2) un premier conducteur (112) qui possède une impédance relativement très faible et dont une extrémité est connectée au premier composant à impédance ;

(3) un second composant à impédance (121) ayant la même impédance que le premier composant à impédance ;

(4) un second conducteur (122) qui possède une impédance relativement très faible et dont une extrémité est connectée au second composant à impédance ; le premier composant à impédance et le premier conducteur, en l'absence d'un événement, étant isolés électriquement du second conducteur et du second composant à impédance ; et

(5) un moyen (5) de connexion sensible à un événement qui, à l'apparition d'un événement, peut effectuer une connexion électrique entre les premier et second conducteurs ;

le premier composant à impédance et le premier conducteur pouvant être connectés en série avec des parties entrante et sortante de composants intermédiaires de l'élément allongé (11) de localisation, et le second composant à impédance et le second conducteur pouvant être connectés en série avec des parties entrante et sortante de composants intermédiaires de l'élément allongé (12) de source.

11. Module selon la revendication 10, comportant un troisième composant à impédance connecté à l'autre extrémité du premier conducteur, et un quatrième composant à impédance connecté à l'autre extrémité du second conducteur, les troisième et quatrième composants ayant la même impédance que les premier et deuxième composants.

## Patentansprüche

1. Verfahren zum Überwachen des Auftretens eines Ereignisses und zum Erfassen und Gewinnen von Information über das Ereignis bei seinem Auftreten, wobei das Verfahren die Bereitstellung eines Systems umfaßt, bei dem beim Auftreten des Ereignisses

(1) eine elektrische Verbindung (E) hergestellt wird zwischen (i) einem langgestreckten elektrisch leitenden Lokalisierungteil (11), das zwischen seinen Enden eine Gesamtimpedanz $Z_{total}$ hat, und (ii) einem langgestreckten elektrisch leitenden Versorgungsteil (12); die Verbindung mit dem Lokalisierungsteil an einem ersten Punkt (1) auf dem Lokalisierungsteil wirksam ist, dessen Ort durch wenigstens eine Charakteristik des Ereignisses definiert ist; die Herstellung der Verbindung die Ausbildung einer Testschaltung ermöglicht, die folgendes aufweist: (a) die Verbindung (E), (b) den Teil des Lokalisierungsteiles (11), der zwischen dem ersten Punkt (1) und einem zweiten Punkt (2), der einen bekannten Ort auf dem Lokalisierungsteil hat, (c) einen Teil des Versorgungsteiles (12) und (d) eine Stromquelle (15), die einen elektrischen Strom bekannter Größe zwischen dem ersten und dem zweiten Punkt auf dem Lokalisierungsteil bewirkt, wobei die Testschaltung eine Abgleichkomponente aufweist, die

(i) mit dem Teil des Lokalisierungsteiles zwischen dem ersten Punkt (1) und dem zweiten Punkt (2) in Reihe geschaltet ist und

(ii) eine Impedanz hat, die im wesentlichen gleich der Differenz zwischen $Z_{total}$ und der Impedanz desjenigen Teiles des Lokalisierungsteiles ist, der zwischen dem ersten und dem zweiten Punkt liegt, und die somit gewährleistet, daß die Impedanz der Testschaltung sich nicht mit dem Ort der Verbindung (E) ändert; und wobei der Strom und das Lokalisierungsteil derart sind, daß durch das Messen des Spannungsabfalls zwischen dem ersten und dem zweiten Punkt die räumliche Beziehung zwischen dem ersten und dem zweiten Punkt bestimmt werden kann;

(2) der Spannungsabfall zwischen dem ersten und dem zweiten Punkt gemessen wird; und

(3) Information bezüglich des Ereignisses aus der im Schritt (2) durchgeführten Messung gewonnen wird.

2. Verfahren nach Anspruch 1,
wobei das Versorgungsteil (12) im wesentlichen die gleichen Impedanz-Charakteristiken wie das Lokalisierungsteil hat und die Abgleichkomponente derjenige Teil des Versorgungsteils ist, der in der Testschaltung vorhanden ist.

3. Verfahren nach Anspruch 1 oder 2,
welches das Messen der Impedanz der Verbindung (E) zwischen dem Lokalisierungsteil und dem Versorgungsteil umfaßt.

4. Verfahren nach einem der vorhergehenden Ansprüche,
wobei das Lokalisierungsteil folgendes aufweist:
(1) eine Vielzahl von voneinander beabstandeten Lokalisierungszonen, wobei jede der Zonen eine Reihe von Punkten hat, mit denen die Verbindung hergestellt werden kann, und
(2) eine Vielzahl von voneinander beabstandeten Verbindungszonen, die die Lokalisierungszonen körperlich trennen und elektrisch miteinander verbinden und die nicht mit dem Versorgungsteil in Verbindung gebracht werden können.

5. Verfahren nach einem der vorhergehenden Ansprüche,
wobei die Stromquelle (15) eine geregelte Stromquelle ist, die einen bekannten festen Strom liefert.

6. Verfahren nach einem der vorhergehenden Ansprüche,
wobei der Spannungsabfall zwischen dem ersten und dem zweiten Punkt bestimmt wird mit einer Spannungsmeßeinrichtung (14), die einen Teil einer Referenzschaltung bildet, wobei die Referenzschaltung folgendes aufweist:
(a) die Spannungsmeßeinrichtung (14);
(b) den Teil des Lokalisierungsteiles, der zwischen dem ersten und dem zweiten Punkt (1) und (2) liegt, und
(c) ein elektrisch leitendes Rückleitungsteil (16), das
(i) mit dem Lokalisierungsteil an dessen Enden elektrisch verbunden ist, und
(ii) im übrigen von dem Lokalisierungsteil isoliert ist,
wobei die Spannungsmeßeinrichtung eine Impedanz hat, die im Vergleich mit der Impedanz der übrigen Komponenten der Referenzschaltung sehr hoch ist.

7. Verfahren nach einem der Ansprüche 2 bis 4,
wobei die Testschaltung eine Referenzimpedanz ($R_f$) hat, die in Reihe mit dem Lokalisierungsteil geschaltet ist, und wobei der Ort des ersten Punktes (1) auf dem Lokalisierungsteil berechnet wird aus dem Verhältnis (i) des Spannungsabfalls zwischen dem ersten Punkt (1) und dem zweiten Punkt (2) auf dem Lokalisierungsteil zu (ii) dem Spannungsabfall über der Referenzimpedanz.

8. Verfahren nach einem der vorhergehenden Ansprüche,
wobei das Ereignis betreffende Information nur dann im Schritt (3) gewonnen wird, wenn das Verhältnis (V/I) innerhalb eines vorgegebenen Bereiches liegt, wobei V die Ausgangsspannung der Stromquelle und I der Strom in der Testschaltung sind.

9. Verfahren nach Anspruch 8,
wobei die Stromquelle (15) eine geregelte Stromquelle ist, die einen Strom mit einem festen Wert liefert, und Information im Schritt (3) nur dann gewonnen wird, wenn der Strom zwischen dem ersten und dem zweiten Punkt im wesentlichen diesen festen Wert hat.

10. Ereignisempfindlicher Modul, der zum Einsatz als Bauelement bei einem Verfahren nach einem der vorhergehenden Ansprüche geeignet ist, wobei der Modul folgendes aufweist:
(1) ein erstes Impedanzelement (111) mit einer wesentlichen Impedanz;
(2) einen ersten Leiter (112), der eine relativ sehr kleine Impedanz hat und von dem ein Ende mit dem ersten Impedanzelement verbunden ist;
(3) ein zweites Impedanzelement (121) mit der gleichen Impedanz wie das erste Impedanzelement;
(4) einen zweiten Leiter (122), der eine relativ sehr kleine Impedanz hat und von dem ein Ende mit dem zweiten Impedanzelement verbunden ist; wobei das erste Impedanzelement und der erste Leiter bei Abwesenheit eines Ereignisses von dem zweiten Leiter und dem zweiten Impedanzelement elektrisch isoliert sind; und
(5) eine ereignisempfindliche Verbindungseinrichtung (5), die beim Auftreten eines Ereignisses eine elektrische Verbindung zwischen dem ersten und dem zweiten Leiter herstellen kann;
wobei das erste Impedanzelement und der erste Leiter mit ankommenden und abgehenden Bereichen von Zwischenelementen des langgestreckten Lokalisierungsteiles (11) in Reihe schaltbar sind und

wobei das zweite Impedanzelement und der zweite Leiter mit ankommenden und abgehenden Bereichen von Zwischenelementen des langgestreckten Versorgungsteiles (12) in Reihe schaltbar sind.

11. Modul nach Anspruch 10, umfassend ein drittes Impedanzelement, das mit dem anderen Ende des ersten Leiters verbunden ist, und ein viertes Impedanzelement, das mit dem anderen Ende des zweiten Leiters verbunden ist, wobei das dritte und das vierte Element die gleiche Impedanz wie das erste und das zweite Element haben.

Fig . 1.

Fig . 2.

Fig . 3.

Fig. 4.

Fig. 5.

Fig. 6.